# EUROPÄISCHE PATENTSCHRIFT

(11) **EP 2 474 031 B1**
(45) Veröffentlichungstag und Bekanntmachung des Hinweises auf die Patenterteilung: **15.04.2020**
(21) Anmeldenummer: 10772990.7
(22) Anmeldetag: 25.08.2010
(51) Int. Cl.: H01L 25/075, H01L 33/54

(54) **VERGOSSENES OPTOELEKTRONISCHES MODUL MIT MEHREREN HALBLEITERBAUELEMENTEN UND VERFAHREN ZUM HERSTELLEN EINES OPTOELEKTRONISCHEN MODULS**
POTTED OPTOELECTRONIC MODULE HAVING A PLURALITY OF SEMICONDUCTOR COMPONENTS AND METHOD FOR PRODUCING AN OPTOELECTRONIC MODULE
MODULE OPTOÉLECTRONIQUE SURMOULÉ AVEC PLUSIEURS COMPOSANTS SEMICONDUCTEURS ET PROCÉDÉ DE FABRICATION D'UN MODULE OPTOÉLECTRONIQUE

(30) Priorität: 03.09.2009 DE 102009039982
(43) Veröffentlichungstag der Anmeldung: 11.07.2012
(73) Patentinhaber: OSRAM Opto Semiconductors GmbH, 93055 Regensburg (DE)
(72) Erfinder: BARTH, Andreas, 91220 Schnaittach (DE); BRICK, Peter, 93051 Regensburg (DE); WITTMANN, Michael, 93087 Alteglofsheim (DE)
(74) Vertreter: Kanzian, Tanja
(86) Internationale Anmeldenummer: PCT/EP2010/062400
(87) Internationale Veröffentlichungsnummer: WO 2011/026768

(56) Entgegenhaltungen:
- WO-A1-2007/080803
- DE-A1-102006 048 592

## Beschreibung

Die vorliegende Erfindung betrifft ein optoelektronisches Halbleiterbauelement, insbesondere ein optoelektronisches Halbleiterbauelement mit einem Grundkörper, der eine Aussparung aufweist, in dem ein erstes optoelektronisches Element und ein zweites optoelektronisches Element angeordnet ist, sowie ein Verfahren zum Herstellen eines optoelektronischen Halbleiterbauelements.

Ein Beispiel für ein solches optoelektronisches Halbleiterbauelement ist ein Modul, in dem mehrere optoelektronische Elemente, bspw. lichtemittierende Dioden, als vereinzelte Halbleiterchips in einem Gehäuse vereint sind. Die optoelektronische Elemente werden in einer Aussparung eines Grundkörpers angeordnet und mit einer Vergussmasse vergossen. Es ist dabei oft problematisch, dass die Hauptausstrahlrichtungen der in das Gehäuse eingebrachten Dioden zueinander leicht unterschiedlich sind. Insbesondere bei Mehrfarben-LEDs kommt es im Fernfeld zu sichtbaren Farbunterschieden in großen Winkelbereichen, weil bei unterschiedlicher Winkelbetrachtung die Lichtemission einzelner Dioden unterschiedlich stark ins Gewicht fällt. Damit gelangt nicht ein für jede Diode konstanter Lichtanteil, welcher beispielsweise für die Erzeugung von weißem Licht durch Lichtmischung notwendig ist, in alle Winkelbereiche. Diese Farbunterschiede sind bei typischen Anwendungen, wie beispielsweise großen Videowänden oder Projektoren, unerwünscht.

Das Dokument US 2005/0 212 405 A1 zeigt ein optoelektronisches Element, in dem zwischen einem optischen Element, bspw. einer Linse, und einem lichtemittierenden Element ein optisches Kopplungsmedium, bspw. ein Gel vorgesehen ist.

Das Dokument US 7,183,587 B2 betrifft einen Montageträger für eine lichtemittierende Halbleitervorrichtung.

Das Dokument DE 10 2006 048 592 A1 beschreibt ein optoelektronisches Modul, das eine Mehrzahl optoelektronischer Komponenten aufweist. Diese sind voneinander beabstandet auf einer Montagefläche befestigt. Zwischen den Elementen (2) kann ein Trennelement (5) vorgesehen sein. Seine Funktion ist als Reflektorelement ausgeführt. Seitlich aufgebrachte Seitenelemente 59 begrenzen das Modul in lateraler Richtung.

Das Dokument WO 2007/080 803 A1 beschreibt eine lichtemittierende Halbleitervorrichtung, in der Phosphor in eine die Vorrichtung umschleißende Füllmasse eingebracht ist.

Der vorliegenden Erfindung liegt das Problem zugrunde, ein optoelektronisches Halbleiterbauelement bereitzustellen, mit dem der oben beschriebene Effekt verringert werden kann.

Dieses Problem wird durch ein optoelektronisches Halbleiterbauelement und ein Verfahren zum Herstellen eines optoelektronischen Halbleiterbauelements gemäß den unabhängigen Patentansprüchen 1 bzw. 9 gelöst.

Weiterbildungen und vorteilhafte Ausgestaltungen des optoelektronischen Halbleiterbauelements bzw. des Verfahrens zum Herstellen eines optoelektronischen Halbleiterbauelements sind in den abhängigen Patentansprüchen angegeben.

### BEISPIELHAFTE AUSFÜHRUNGSFORMEN

Verschiedene Ausführungsformen des optoelektronischen Halbleiterbauelements weisen einen Grundkörper mit einer darin gebildeten Aussparung auf. Sie weisen jeweils ein erstes optoelektronisches Element, ein zweites optoelektronisches Element und ein oberflächenstrukturierendes Element auf. Das erste optoelektronische Element und das zweite optoelektronische Element sind durch eine Füllmasse in die Aussparung einbettet. Das oberflächenstrukturierende Element gestaltet eine Oberfläche der Füllmasse derart, dass wenigstens zwei gewölbte Bereiche der Oberfläche bestehen, wobei
- das oberflächenstrukturierende Element durch einen sich seitlich in die Aussparung erstreckenden und darin eine Einschnürung bildenden Vorsprung des Grundkörpers gebildet ist, und/oder
- das oberflächenstrukturierende Element durch einen in der Aussparung verlaufenden Steg gebildet ist, der nicht mit seitlichen Innenflächen der Aussparung sondern mit einer Grundfläche der Aussparung verbunden ist, und/oder
- das oberflächenstrukturierende Element brückenförmig in der Aussparung ausgebildet und über jeweilige Verankerungen an dem Grundkörper befestigt ist und auf oder an der Oberfläche der Füllmasse verläuft.

Verschiedene Ausführungsformen des Verfahrens zum Herstellen eines optoelektronischen Halbleiterbauelements weisen die folgenden Schritte auf:
- Bereitstellen eines Grundkörpers mit einer darin gebildeten Aussparung und einem oberflächenstrukturierende Element;
- Anordnen von einem ersten optoelektronischen Element und einem zweiten optoelektronischen Element in der Aussparung; und
- Füllen der Aussparung mit einer Füllmasse, wobei durch das oberflächenstrukturierende Element wenigstens zwei gewölbte Bereiche einer Oberfläche der Füllmasse gebildet werden, wobei
- das oberflächenstrukturierende Element durch einen sich seitlich in die Aussparung erstreckenden und darin eine Einschnürung bildenden Vorsprung des Grundkörpers gebildet ist, und/oder
- das oberflächenstrukturierende Element durch einen in der Aussparung verlaufenden Steg gebildet ist, der nicht mit seitlichen Innenflächen der Aussparung sondern mit einer Grundfläche der Aussparung verbunden ist, und/oder
- das oberflächenstrukturierende Element brückenförmig in der Aussparung ausgebildet und über jeweilige Verankerungen an dem Grundkörper befestigt ist und auf oder an der Oberfläche der Füllmasse verläuft.

Es ist ein Grundgedanke verschiedener Ausführungsformen, dass ein optoelektronisches Bauelement bereitgestellt wird, das wenigstens zwei optoelektronische Elemente, wie bspw. lichtemittierende Dioden, aufweist. Die optoelektronischen Elemente sind von einem Füllmaterial umschlossen, das typischerweise transparent ist. Das Füllmaterial weist eine Oberfläche auf, über die Strahlung ausgekoppelt wird, die von den optoelektronischen Elementen emittiert ist. Durch das Vorsehen von oberflächenstrukturierenden Elementen ist die Oberfläche in zwei Bereiche gegliedert, die jeweils gewölbt sind. Damit kann eine Oberfläche erzeugt werden, bei der die Oberfläche aus Sicht der einzelnen optoelektronischen Elemente annähernd gleich gestaltet ist. Die einzelnen optoelektronischen Elemente strahlen so jeweils in vergleichbarer Art in alle Raumrichtungen ab. Es wird insbesondere eine bessere Farbhomogenität in großen Winkelbereichen des optoelektronischen Halbleiterbauelements erzielt. Dies ist besonders vorteilhaft, wenn das optoelektronische Halbleiterbauelement für die Erzeugung von weißem Licht aus der Überlagerung von durch die optoelektronischen Elemente emittierte Strahlung ausgestaltet ist, wobei jedes der optoelektronischen Elemente auf einem anderen Farbspektrum emittiert. Damit können Farbunterschiede in typischen Anwendungen, wie bspw. Videowänden oder Projektoren, verringert werden.

In einer Ausführungsform des optoelektronischen Halbleiterbauelements ist das oberflächenstrukturierende Element durch einen sich in die Aussparung erstreckenden Vorsprung des Grundkörpers gebildet. Dabei entsteht eine Einschnürung der Aussparung. Bei einem Auffüllen der Aussparung mit Füllmasse bildet sich aufgrund der Oberflächenspannung der Füllmasse an der Einschnürung eine Strukturierung der Oberfläche der Füllmasse in zwei Bereiche mit jeweils einem gewölbten Oberflächenprofil. So wird durch das Vorsehen des Vorsprungs die Oberfläche der Füllmasse in zwei Bereiche gegliedert.

In einer Ausführungsform des optoelektronischen Halbleiterbauelements ist das oberflächenstrukturierende Element durch einen in der Aussparung verlaufenden Steg gebildet. An dem Steg entsteht eine Kontaktspannung zwischen der Füllmasse und dem Stegmaterial. Damit bilden sich an beiden Seiten des jeweils Bereiche der Oberfläche, die aufgrund der Oberflächenspannung gewölbt ausgestaltet sind. Der Steg steht beispielsweise in Kontakt mit der Oberfläche, so dass durch die Höhe des Steges die Krümmung und Ausrichtung der Wölbung beeinflusst wird.

In einer Ausführungsform des optoelektronischen Halbleiterbauelements ist das oberflächenstrukturierende Element brückenförmig in der Aussparung ausgebildet. Dadurch wird der Strahlgang der von den optoelektronischen Elementen emittierten Strahlung minimal beeinflusst.

In einer Ausführungsform des optoelektronischen Halbleiterbauelements sind die zwei gewölbten Bereiche jeweils konkav gewölbt. Durch den so beeinflussten Strahlverlauf der von den optoelektronischen Elementen emittierten Strahlung wird eine besonders gute Farbtreue der überlagerten Spektren über einen großen Raumwinkel erzielt.

In einer Ausführungsform des optoelektronischen Halbleiterbauelements sind das erste optoelektronische Element und das zweite optoelektronische Element jeweils als Strahlungsquelle ausgestaltet. Dabei sind sowohl Spektren im nichtsichtbaren Bereich, als auch im Bereich des sichtbaren Lichts denkbar.

In einer Ausführungsform des optoelektronischen Halbleiterbauelements weist das erste optoelektronische Element ein anderes Emissionsspektrum als das zweite optoelektronische Element auf. Durch die Überlagerung der jeweiligen Spektren der optoelektronischen Elemente werden unterschiedliche Farbspektren der von dem gesamten optoelektronischen Halbleiterbauelement emittierten Strahlung erzielt.

In einer Ausführungsform des optoelektronischen Halbleiterbauelements ist die Füllmasse eine Vergussmasse ist. Dadurch kann eine besonders einfache Herstellung des optoelektronischen Halbleiterbauelements erreicht werden. Zudem sind die optoelektronischen Elemente nach dem Verguss ohne besondere Kontaktflächen von der Füllmasse umschlossen.

In einer Ausführungsform des optoelektronischen Halbleiterbauelements weist die Vergussmasse eines der der folgenden Materialen aufweist:
- Epoxydharz;
- Akrylharz;
- Silikon und
- Silikonharz.
Diese Materialien zeichnen sich insbesondere durch ihre Transparenz im Bereich des sichtbaren Lichts als auch durch die leichte Verarbeitbarkeit bei der Herstellung des optoelektronischen Halbleiterbauelements aus. Als Vergussmasse eigenet sich auch ein auf ein oder mehrere oben genannte Materialien basierendes Hybrid, bzw. eine entsprechende Mischung.

In einer Ausführungsform des Verfahrens zur Herstellung eines optoelektronischen Halbleiterbauelements wird die Oberfläche der Füllmasse ausgehärtet. Dadurch wird die durch das oberflächenstrukturierende Element gebildete Oberflächenstruktur der Füllmasse dauerhaft verfestigt.

In einer Ausführungsform des Verfahrens zur Herstellung eines optoelektronischen Halbleiterbauelements wird die Füllmasse durch ein Abkühlen oder einen Glasübergang ausgehärtet

In einer Ausführungsform des Verfahrens zur Herstellung eines optoelektronischen Halbleiterbauelements wird die Füllmasse durch ein Vergießen in die Ausführungsform eingebracht.

### KURZE BESCHREIBUNG DER ZEICHNUNGEN

Verschiedene Ausführungsbeispiele der erfindungsgemäßen Lösung sowohl als auch ein nicht zur Erfindung gehörendes Erläuterungsbeispiel werden im Folgenden anhand der Zeichnungen näher erläutert. In den Figuren geben die erste(n) Ziffer(n) eines Bezugszeichens die Figur an, in denen das Bezugzeichen zuerst verwendet wird. Die gleichen Bezugszeichen werden für gleichartige oder gleich wirkende Elemente bzw. Eigenschaften in allen Figuren verwendet.

Es zeigen:
- **Fig. 1a**: eine schematische Darstellung einer Aufsicht eines optoelektronischen Halbleiterbauelements gemäß einem ersten Ausführungsbeispiel;
- **Fig. 1b**: eine schematische Darstellung eines Querschnitts durch das in **Fig. 1a** gezeigte optoelektronische Halbleiterbauelement entlang einer Schnittachse A-A;
- **Fig. 1c**: eine schematische Darstellung eines Querschnitts durch eine erste Ausgestaltung des in **Fig. 1a** gezeigten optoelektronischen Halbleiterbauelements entlang einer Schnittachse B-B;
- **Fig. 1d**: eine schematische Darstellung eines Querschnitts durch eine zweite Ausgestaltung des in **Fig. 1a** gezeigten optoelektronischen Halbleiterbauelements entlang einer Schnittachse B-B;
- **Fig. 2a**: eine schematische Darstellung einer Aufsicht eines optoelektronischen Halbleiterbauelements gemäß einem zweiten Ausführungsbeispiel;
- **Fig. 2b**: eine schematische Darstellung eines Querschnitts durch das in **Fig. 2a** gezeigte optoelektronische Halbleiterbauelement entlang einer Schnittachse A-A;
- **Fig. 3a**: eine schematische Darstellung einer Aufsicht eines optoelektronischen Halbleiterbauelements gemäß einem nicht zur Erfindung gehörenden Erläuterungsbeispiel;
- **Fig. 3b**: eine schematische Darstellung eines Querschnitts durch das in **Fig. 3a** gezeigte optoelektronische Halbleiterbauelement entlang einer Schnittachse A-A;
- **Fig. 3c**: eine schematische Darstellung einer Aufsicht eines optoelektronischen Halbleiterbauelements gemäß einem dritten Ausführungsbeispiel;
- **Fig. 4a**: eine schematische Darstellung einer Aufsicht eines optoelektronischen Halbleiterbauelements gemäß einem vierten Ausführungsbeispiel;
- **Fig. 4b**: eine schematische Darstellung eines Querschnitts durch das in **Fig. 4a** gezeigte optoelektronische Halbleiterbauelement entlang einer Schnittachse A-A und
- **Fig. 5**: ein Ablaufdiagramm eines Ausführungsbeispiels eines Verfahrens zum Herstellen eine optoelektronischen Halbleiterbauelements.

### AUSFÜHRUNGSBEISPIELE DES OPTOELEKTRONISCHEN HALBLEITERBAUELEMENTS

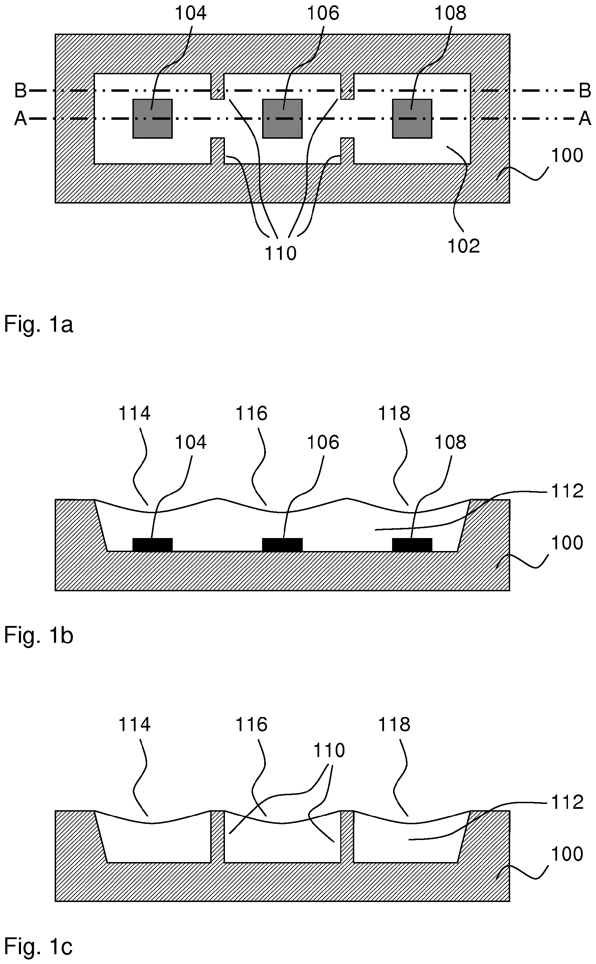

**Fig. 1a** zeigt eine schematische Darstellung einer Aufsicht eines ersten Ausführungsbeispiels eines optoelektronischen Halbleiterbauelements. Das optoelektronische Halbleiterbauelement weist einen Grundkörper 100 auf. In dem Grundkörper 100 ist eine Aussparung 102 vorgesehen. In der Aussparung 102 sind ein erstes optoelektronisches Element 104, ein zweites optoelektronisches Element 106 und ein drittes optoelektronisches Element 108 angeordnet. Der Grundkörper 100 weist Vorsprünge 110 auf, die sich in die Aussparung 102 erstrecken und in dieser Einschnürungen bilden. In die Aussparung 102 ist eine Füllmasse eingebracht, die das erste optoelektronische Element 104, das zweite optoelektronische Element 106 und das dritte optoelektronische Element 108 einbettet und diese bedeckt.

Der Grundkörper 100 entspricht einem Träger für die optoelektronischen Elemente mit einem Gehäuse zum Schutz derselben. Der Grundkörper 100 kann einstückig oder mehrteilig ausführt sein. Beispielsweise ist der Grundkörper 100 durch das Umspritzen eines Trägers oder eines Leiterrahmens (*leadframe*) mit einem Kunststoffmaterial gebildet. Dabei können die Materialen für den Grundkörper aus einer Vielzahl aus der Halbleiterfertigung bekannter, geeigneter Materialen gewählt sein. Es kann beispielsweise ein Temperaturbereich für eine Betriebstemperatur des optoelektronischen Halbleiterbauelements berücksichtigt sein. Beispielsweise können geeignete Materialien mit einem hohen Reflexionskoeffizienten gewählt sein. Dadurch kann beispielsweise die Abstrahlleistung des optoelektronischen Halbleiterbauelements erhöht werden. Dazu kann der Grundkörper 100 beispielsweise einen Träger aufweisen, der einen Reflektor trägt, in dem sich die Aussparung 102 befindet. Es ist denkbar, dass der Grundkörper 100 oder Teile des Grundkörpers durch ein Spritzgussverfahren erzeugt ist.

Der Grundkörper 100 kann aus jedem geeigneten Material bestehen. Anstelle eines Reflektors ist ein absorbierender Teil des Grundkörpers 100, bspw. ein schwarzes Gehäuse denkbar. Durch die beschriebene Anordnung kann bei einem absorbierenden Teil, bei dem aufgrund der fehlenden Streuung am Gehäusematerial stärkere Farbinhomogenitäten auftreten, eine erhebliche Verbesserung der Farbhomogenität erreicht werden.

Die Aussparung 102 kann als Ausnehmung in dem Grundkörper 100 gebildet sein. Sie kann beispielsweise bereits bei Bildung des Grundkörpers 100 gebildet sein oder nachträglich in dem Grundkörper 100 ausgebildet sein. Die Aussparung 102 kann glatte Innenflächen aufweisen. Es ist möglich, dass die Innenflächen strukturiert sind, beispielsweise um eine besser Abstrahlleistung des optoelektronischen Halbleiterbauelements zu erzielen. Die seitlichen Innenflächen können senkrecht in dem Grundkörper 100 gebildet sein. Ebenso ist es möglich, dass die seitlichen Innenflächen schräg ausgebildet sind, beispielsweise in dem sie derart gebildet sind, dass sich die Aussparung 102 hin zur Öffnung verbreitet. Die so gebildeten Ausformschrägen haben beispielsweise einen Winkel von mehr als 4° abweichend von der Senkrechten zur Grundfläche der Aussparung 102. Damit wird ebenfalls die Abstrahlleistung des optoelektronischen Halbleiterbauelements verbessert.

Das erste optoelektronische Element 104, das zweite optoelektronische Element 106 und das dritte optoelektronische Element 108 sind jeweils als einzelne Halbleiterchips ausgestaltet. Dabei sind sowohl ein anorganischer Halbleiter, beispielsweise ein III-V Halbleiter, wie ein GaAs-Halbleiter oder ein GaN-Halbleiter, als auch ein organischer Halbleiter denkbar. Dabei sind auf einem Substrat aufgewachsene Epitaxieschichten als Halbleiter möglich. Das Substrat umfasst Materialien wie beispielsweise, wie SiC, Saphir, Ge, Si, GaAs, GaN oder GaP. Die Epitaxieschichten weisen beispielsweise quarternäre Halbleiter, wie AlInGaN für ein blau oder grünes Emmissionsspektrum im sichtbaren Bereich auf oder AlInGaP für ein rotes Emmissionsspektrum im sichtbaren Bereich. Ebenso kann die Epitaxieschicht quinternäre Halbleiter aufweisen. Ein solcher Halbleiter ist beispielsweise AlGaInAsP, der zur Emssion von Strahlung im Infrarotbereich dienen kann.

Die Anordnung der optoelektronischen Elemente erfolgt in Bezug zu einer optischen Achse, die als Normale durch eine Öffnungsfläche der Aussparung 102 verläuft, so dass die optoelektronischen Elemente Strahlung im Wesentlichen durch die Öffnung der Aussparung emittieren. Die optoelektronischen Elemente können sowohl optische Sensoren als auch vor allem Strahlungsquellen sein. Dabei kommen sowohl lichtemittierende Dioden als auch organische lichtemittierende Dioden in Betracht.

Die Vorsprünge 110 ragen von dem Grundkörper in die Aussparung 102. Sie können aus dem gleichen Material wie der Grundkörper bestehen und mit diesem einstückig gefertigt sein. Denkbar ist ein Spritzgussverfahren wenigstens der gesamten Innengeometrie der Aussparung 102. Es ist aufgrund der Geometrie ein geeignetes Design eines Formkerns für ein Werkzeug denkbar. Es ist ebenso denkbar, dass sie an dem Grundkörper angebracht sind und/oder aus einem anderen Material bestehen. Jeder der Vorsprünge 110 kann sich über die gesamte Tiefe einer jeweiligen seitlichen Innenfläche der Ausnehmung 110 erstrecken oder nur über einen Teil derselben. Dabei ist jegliche Variation hinsichtlich Ausgestaltung und Anordnung der Vorsprünge denkbar, soweit durch sie eine Oberfläche der Füllmasse strukturiert ist.

Die Vorsprünge 110 können unterschiedliche Größen haben. Die durch die Vorsprünge 110 gebildet Einschnürungen in der Aussparung 102 haben in einigen Ausführungsbeispielen Breiten von mehr als 100 µm.

Die Füllmasse ist ein transparentes Material, das zur Umhüllung der optoelektronischen Elemente dient. Als Füllmaterial kann ein transparentes Material verwendet sein, das UV-initiiert oder Licht-initiiert kationisch härtende Eigenschaften besitzt. Für die Füllmasse kommen beispielsweise ein Silikon oder ein Epoxydharz in Betracht. Auch Acrylharze, wie PMMA, oder Silikonharze können verwendet sein. Die Füllmasse kann weiterhin ein Diffusermaterial enthalten, um eine diffuse Strahlungsauskopplung von in den optischen Elementen erzeugter Strahlung zu ermöglichen. Dazu kann die Füllmasse ein Diffuserpartikel enthalten, die in der Füllmasse verteilt sind. Sie dienen dazu, auf sie treffende Strahlung, wie Licht, diffus zu streuen. Die Verteilung der Diffuserpartikel kann möglichst gleich verteilt sein, Es ist aber ebenso denkbar durch geeignete Herstellungsprozesse die Verteilung der Diffuserpartikel derart zu wählen, dass besondere optische Eigenschaften der Füllmasse erzielt werden. Durch den Anteil der Diffuserpartikel in der Füllmasse werden sowohl die Absorptionseigenschaften als auch die Diffusionseigenschaften der Füllmasse beeinflusst. Der Anteil der Diffuserpartikel an der Füllmasse beträgt beispielsweise zwischen ca. 0,15% und ca. 2,0%. Er kann aber entsprechend der gewünschten optischen Eigenschaften der Füllmasse höher oder niedriger gewählt sein. Die Verwendung von Diffuserpartikeln ist beispielsweise aus dem Dokument [1] bekannt, dessen Offenbarung hiermit durch Rückbezug in das vorliegende Dokument aufgenommen wird.

Ebenso kann die Füllmasse Absorbermaterialen enthalten, um die optischen Eigenschaften des optoelektronischen Halbleiterbauelements je nach Bedarf zu beeinflussen.

Die Struktur des ersten Ausführungsbeispiels des optoelektronischen Halbleiterbauelements wird anhand der **Fig. 1b** deutlicher. Die **Fig. 1b** zeigt die schematische Darstellung eines Querschnitts durch das in **Fig. 1a** dargestellte optoelektronische Halbleiterbauelement entlang der Schnittachse A-A. Das erste optoelektronische Element 104, das zweite optoelektronische Element 106 und das dritte optoelektronische Element 108 sind auf einem Boden der Aussparung in dem Grundkörper 100 angeordnet. Die Aussparung ist mit der Füllmasse 112 aufgefüllt, so dass die optoelektronischen Elemente eingebettet sind. Dabei hat die Füllmasse 112 eine Oberfläche, die dem Boden der Aussparung gegenüberliegt. Die Oberfläche ist durch die Vorsprünge in einen ersten Bereich 114, einen zweiten Bereich 116 und einen dritten Bereich 118 strukturiert. Die Bereiche bilden damit lokale Füllformen auf der Lichtaustrittsseite für jeden einzelnen der optoelektronischen Elemente.

Die lokalen Füllformen entstehen unter anderem bei der Einbringung der Füllmasse 112 in die Aussparung. Die Formen sind dabei beispielsweise abhängig von der Oberflächenspannung der Füllmasse 112 in der flüssigen Phase, der freien Oberflächenenergie des Materials, dass die Kontaktfläche zwischen Füllmasse und dem Grundkörper 100 bildet und der Grenzflächenspannung an dieser Kontaktfläche. Durch eine geeignete Materialwahl und/oder Prozessierung können die physikalischen Parameter derart eingestellt werden, dass eine geeignete lokale Füllform entsteht. Dabei kann die Oberfläche, wie dargestellt, in drei konkave Bereiche geformt werden. Es ist aber ebenso denkbar, dass diese Bereiche in einer anderen Art gewölbt werden, beispielsweise ist eine konvexe Wölbung der Oberfläche denkbar. Auch ist es denkbar, dass die Bereiche zueinander verschiedene lokale Wölbungen der Oberfläche aufweisen, bspw. indem der erste Bereich 114 konvex gewölbt ist und der zweite Bereich 116 konkav gewölbt ist.

**Fig. 1c** zeigt eine schematische Darstellung eines Querschnitts durch eine erste Ausgestaltung des in **Fig. 1a** gezeigten optoelektronischen Halbleiterbauelements entlang einer Schnittachse B-B. Diese Schnittachse B-B verläuft parallel versetzt zu der Schnittachse A-A in der **Fig. 1b****.**

Dargestellt ist der Grundkörper 100, der zwei Vorsprünge 110 aufweist. Die Vorsprünge 110 haben die gleiche Höhe wie die Aussparung im Grundkörper 100. Die Aussparung ist mit der Füllmasse 102 gefüllt. Diese benetzt die Seitenwände der Vorsprünge 110. Die Oberfläche der Füllmasse 102 wird durch die Vorsprünge 110 in einen ersten Bereich 114, einen zweiten Bereich 116 und einen dritten Bereich 118 gegliedert. Durch die Benetzung der Seitenwände der Vorsprünge 110 und der der Aussparung zugewandten Innenwände des Grundkörper 100 sowie der Oberflächenspannung der Füllmasse 102 weisen die Bereiche jeweils eine gewölbte Form auf. Die Wölbung ist dabei wie in Bezug zur **Fig. 1b** dargestellt bestimmt. Sie ist sowohl in **Fig. 1b** und in **Fig. 1c** nur beispielhaft wiedergegeben.

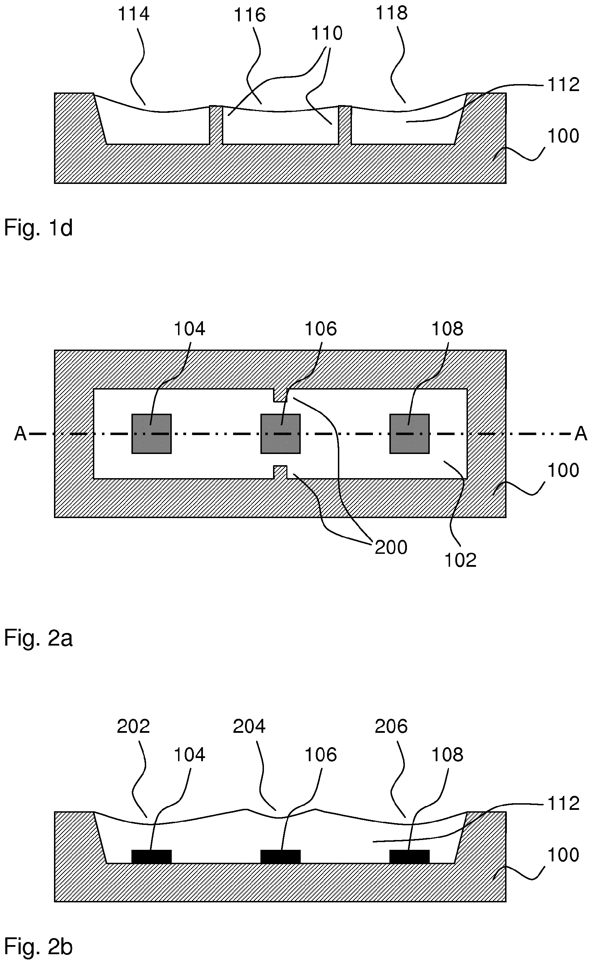

**Fig. 1d** zeigt eine schematische Darstellung eines Querschnitts durch eine zweite Ausgestaltung des in **Fig. 1a** gezeigten optoelektronischen Halbleiterbauelements entlang einer Schnittachse B-B.

Die zweite Ausgestaltung der **Fig. 1d** unterscheidet sich von der ersten Ausgestaltung der **Fig. 1c** dadurch, dass die Vorsprünge 110 eine geringere Höhe als die Aussparung im Grundkörper 100 haben. Dadurch wären beispielsweise geringere Füllhöhen möglich. Es ist möglich, die Ausformung der Bereiche der Oberfläche der Füllmasse 112 durch die Höhe der Vorsprünge 110 zu gestalten.

Ebenfalls ist des denkbar, die Ausformung der Bereich der Oberfläche der Füllmasse 112 durch die Position der Vorsprünge 110 in Bezug auf die Anordnung der optoelektronischen Elemente zu beeinflussen. Dies wird nachfolgend unter Bezug zu **Fig. 2a** näher erläutert.

**Fig. 2a** zeigt eine schematische Darstellung einer Aufsicht eines zweiten Ausführungsbeispiels eines optoelektronischen Halbleiterbauelements. Das zweite Ausführungsbeispiel weist einen zu dem ersten Ausführungsbeispiel der **Fig. 1a** **-** **Fig. 1d** gleichartigen Aufbau auf. Es kann entsprechend der beschrieben möglichen Ausgestaltungen und Variationen des ersten Ausführungsbeispiels ausgebildet sein. Wesentlich unterscheidet sich das zweite Ausführungsbeispiel dadurch, dass an dem Grundkörper 100 ausgebildete Vorsprünge 200 und 202 vorgesehen sind, die in einer Linie mit einem der optoelektronischen Elemente, hier mit dem zweiten optoelektronischen Element 116, angeordnet sind. Dadurch wird eine von dem ersten Ausführungsbeispiel der **Fig. 1a** - **Fig. 1d** verschiedene Gestaltung der Oberfläche der Füllmasse erzielt. Die Gestaltung wird anhand der **Fig. 2b****,** die einen Querschnitt des zweiten Ausführungsbeispiels entlang einer Schnittachse A-A zeigt. Die Oberfläche der Füllmasse 112 ist durch das Vorsehen der Vorsprünge 200 in einen ersten Bereich 202, einen zweiten Bereich 204 und einen dritten Bereich 206 gegliedert. Der zweite Bereich 204 nimmt einen kleineren Anteil der Oberfläche ein, als der erste Bereich 202 und der dritte Bereich 206. Die Bereiche sind dabei gewölbt. Weil der zweite Bereich 204 einen geringeren Anteil an der Oberfläche als die beiden anderen Bereiche einnimmt, ist der Krümmungsradius der Wölbung verschieden von den anderen Bereichen. Es wird deutlich, dass durch die Positionierung und Stärke der Vorsprünge Einfluss auf die Struktur der Oberfläche der Füllmasse genommen werden kann.

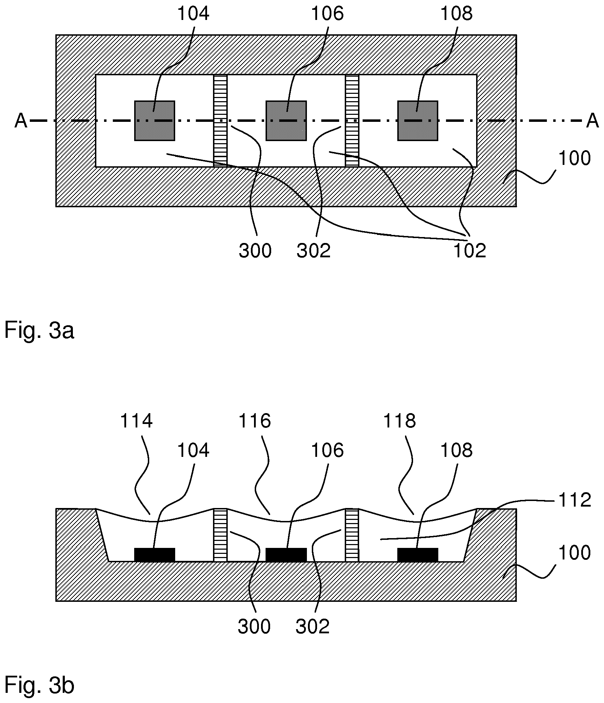

**Fig. 3a** zeigt eine schematische Darstellung einer Aufsicht eines nicht zur Erfindung gehörenden Erläuterungsbeispiels eines optoelektronischen Halbleiterbauelements. Das Erläuterungsbeispiel weist einen zu dem ersten Ausführungsbeispiel der **Fig. 1a** - **Fig. 1d** und zu dem zweiten Ausführungsbeispiel der **Fig. 2a** - **Fig. 2b** gleichartigen Aufbau auf. Es kann entsprechend der beschrieben möglichen Ausgestaltungen und Variationen des ersten Ausführungsbeispiels und des zweiten Ausführungsbeispiels ausgebildet sein. Wesentlich unterscheidet sich das Erläuterungsbeispiel dadurch, dass sich den an dem Grundkörper 100 ausgebildete ersten Steg 300 und dem ebenfalls am an dem Grundkörper ausgebildeten zweiten Steg 302, die sich durch die Aussparung 102 erstrecken. Der erste Steg 300 ist zwischen dem ersten optoelektronischen Element 104 und dem zweiten optoelektronischen Element 106 angeordnet. Der zweite Steg 302 ist zwischen dem zweiten optoelektronischen Element 106 und dem dritten optoelektronischen Element 108 angeordnet. Die Aussparung 102 wird dadurch in drei Bereiche untergliedert. Ebenso wird dadurch die Oberfläche der Füllmasse in einen ersten Bereich 114, einen zweiten bereich 116 und einen dritten Bereich 118 untergliedert, wie in **Fig. 3b** dargestellt ist.

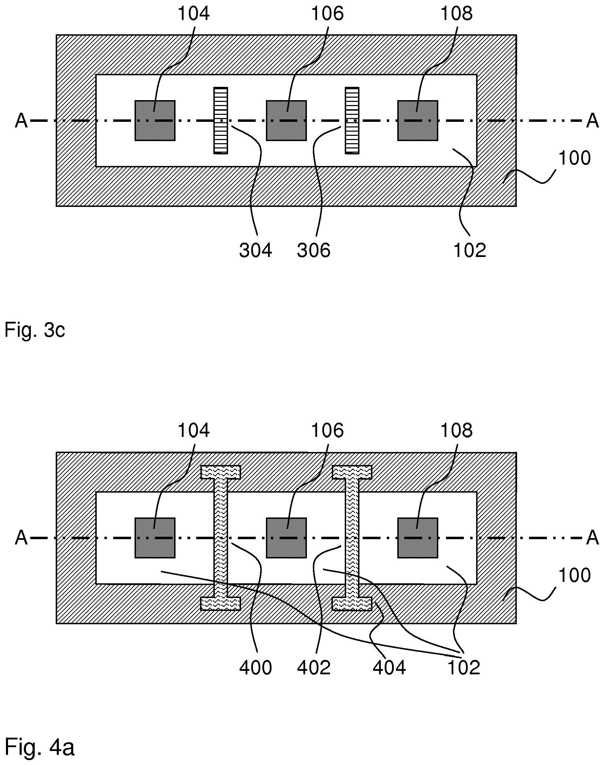

Ein dritter Ausführungsbeispiel der Erfindung ist anhand der **Fig. 3c** dargestellt. Dieses Ausführungsbeispiel unterscheidet sich von der Ausgestaltung der **Fig. 3a** und **Fig. 3b** darin, dass sie einen dritten Steg 304 und einen vierten Steg 306 anstelle des ersten Stegs 300 und des zweiten Stegs 302 aufweisen. Der dritte Steg 304 und der vierte Steg 306 zeichnen sich dadurch aus, dass sie nicht mit den seitlichen Innenflächen der Aussparung sondern mit einer Grundfläche der Aussparung verbunden sind und durch diese getragen werden. Dabei erstrecken sich der dritte Steg 304 und der vierte Steg 306 durch einen Teil der Aussparung 102. Sie stehen zumindest teilweise in Kontakt mit der Grundfläche der Aussparung 102 und werden so getragen. Durch die zwischen den seitlichen Innenflächen und den Stegen bestehende Lücke kann bei einer Herstellung des optoelektronischen die Aussparung besser mit der Füllmasse aufgefüllt werden. Auch kann durch diese Anordnung eine andere Strukturierung der Oberfläche und damit eine andere Abstrahlcharakteristik des optoelektronischen Halbleiterbauelements erzielt werden.

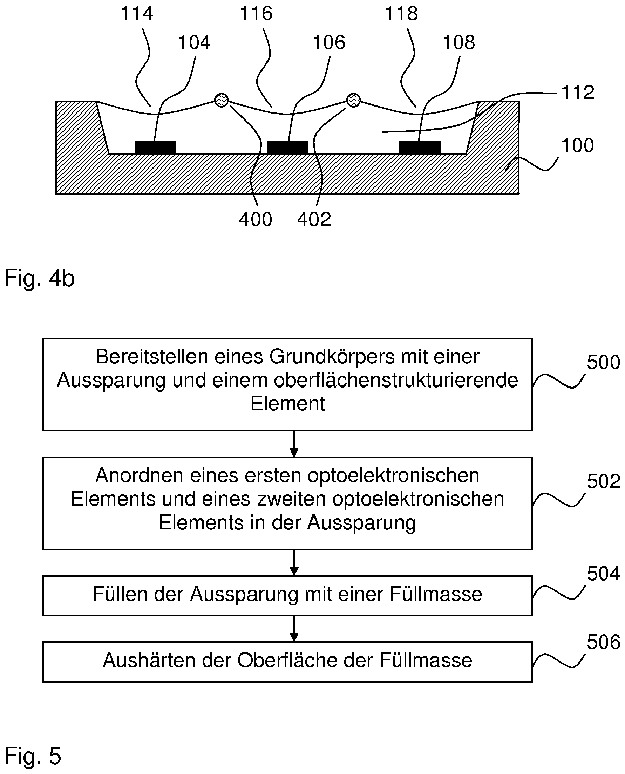

**Fig. 4a** zeigt eine schematische Darstellung einer Aufsicht eines vierten Ausführungsbeispiels eines optoelektronischen Halbleiterbauelements. Das vierte Ausführungsbeispiel weist einen zu dem ersten Ausführungsbeispiel der **Fig. 1a** - **Fig. 1d****,** zu dem zweiten Ausführungsbeispiel der **Fig. 2a** - **Fig. 2b** und zu dem dritten Ausführungsbeispiel der **Fig. 3a** - **Fig. 3c** gleichartigen Aufbau auf. Es entscheidet sich jedoch von diesen wesentlich dadurch, dass an der Stelle von einem Vorsprung oder einem Steg eine erste Brücke 400 und eine zweite Brücke 402 vorgesehen sind. Die erste Brücke 400 und die zweite Brücke sind über jeweilige Verankerungen, bspw. über eine Verankerung 404, an dem Grundkörper 100 befestigt. Sie können aber auch einstückig mit dem Grundkörper 100 ausgeführt sein. Die erste Brücke 400 und die zweite Brücke 402 verlaufen auf oder an der Oberfläche des Füllmaterials. Dies ist zur Verdeutlichung in der Fig. 4b dargestellt, die eine schematische Darstellung eines Querschnitts durch das in **Fig. 4a** gezeigte optoelektronische Halbleiterbauelement entlang einer Schnittachse A-A zeigt.

Die erste Brücke 400 und die zweite Brücke 402 können aus verschiedenen Materialen hergestellt sein. Denkbar ist es, dass sie Materialen beinhalten, die im Grundkörper vorhanden sind. In einer möglichen Ausführung weisen die Brücken Fasern auf, die in idealer Weise im Spektrum der von den optoelektronischen Bauelementen emittierten Strahlung transparent sind. Bevorzugt können dünnen Glasfasern verwendet werden. Durch eine geeignete Materialwahl kann die Kontaktspannung mit der Oberfläche der Füllmasse und damit die Wölbung der Bereiche an der Oberfläche der Füllmasse beeinflusst werden.

Auch wenn sämtliche Ausführungsbeispiele der **Fig. 1a** bis **Fig. 4b** in Zusammenhang mit drei optoelektronischen Elementen beschrieben wurden, so ist jedoch jede andere Anzahl an optoelektronischen Elemente denkbar, soweit wenigstens zwei optoelektronische Elemente vorhanden sind. Die Anzahl an drei optoelektronischen Elementen erlaubt beispielsweise ein optoelektronisches Halbleiterbauelement, in deren Spektren die Farben Rot, Blau und Grün vorhanden sind. Ebenso ist es denkbar, vier optoelektronische Elemente vorzusehen, um beispielsweise durch das Vorsehen von zwei optoelektronischen Elemente, die vor allem auf einem grünen Spektrum abstrahlen, ein optoelektronisches Halbleiterbauelement bereitzustellen, das ein weißes überlagertes Spektrum abstrahlt. Ein solches Spektrum kommt dem Spektrum der Sonnenstrahlung sehr nahe. Durch die Anzahl und Auswahl der optoelektronischen Elemente lassen sich sowohl Strahlungsintensität, als auch die Farbtemperatur des abgestrahlten Lichts nach Bedarf einstellen.

### AUSFÜHRUNGSBEISPIELE DES VERFAHRENS ZUR HERSTELLUNG EINES OPTOELEKTRONISCHEN HALBLEITERBAUELEMENTS

Die **Fig. 5** zeigt das Ablaufdiagramm eines Ausführungsbeispiels eines Verfahrens zur Herstellung eines optoelektronischen Halbleiterbauelements.

In einem ersten Schritt 500 wird ein Grundkörper mit einer Aussparung und einem oberflächenstrukturierende Element bereitgestellt. Der Grundkörper entspricht einem Träger für die optoelektronischen Elemente mit einem Gehäuse zum Schutz derselben, wie er in Bezug auf die Ausführungsbeispiele der **Fig. 1a** bis **Fig. 4b** beschrieben ist. Die Aussparung ist in dem Grundkörper vorgesehen. Sie kann bereits bei der Erstellung des Grundkörpers entstehen, bspw. indem ein entsprechendes Gehäuse an den Träger angebracht ist, oder indem die Aussparung durch eine entsprechende Prozessierung, bspw. einem Ätzverfahren, in dem Grundkörper erzeugt ist. Das oberflächenstrukturierende Element ist an dem Grundkörper angebracht. Seine Funktion und Ausgestaltung entspricht dem oberflächenstrukturierenden Element, wie es in Bezug auf die Ausführungsbeispiele der **Fig. 1a** bis **Fig. 4b** beschrieben ist. Das oberflächenstrukturierende Element kann bereit bei Erstellung des Grundkörpers oder nachträglich an diesem angebracht bzw. geformt werden.

In einem zweiten Schritt 502 werden in der Aussparung ein erstes optoelektronisches Element und ein zweites optoelektronisches Elements angeordnet. Das erste optoelektronische Element und das zweite optoelektronische Element sind jeweils als einzelne Halbleiterchips ausgestaltet. Dabei sind sowohl ein anorganischer Halbleiter, beispielsweise ein III-V Halbleiter, wie ein GaAs-Halbleiter, als auch ein organischer Halbleiter denkbar. Sie können als oder als ungehäustes Halbleiterplättchen (*bare die*) in der Aussparung angeordnet werden. Es ist denkbar, dass auf die aktive Seite eines oder mehrere der Halbleiterplättchen eine Lumineszenzkonversionsschicht aufgebracht ist. In der Lumineszenzkonversionsschicht wird in dem ein Teil der von dem Halbleiterplättchen emittierten Primärstrahlung in eine Strahlung von anderer Wellenlänge konvertiert. In der Regel umfasst sie ein strahlungsdurchlässiges Matrixmaterial und einen in das Matrixmaterial eingebrachten Leuchtstoff. Der in dem Matrixmaterial eingebrachte Leuchtstoff absorbiert zumindest einen Teil der von dem Halbleiterplättchen emittierten Strahlung und emittiert Strahlung in einem anderen Wellenlängenbereich. Als Leuchtstoffe werden beispielsweise anorganische Leuchtstoffe verwendet, wie beispielsweise mit seltenen Erden dotierte Granate. Es können ebenso organische Leuchtstoffe, wie Perylen, oder Mischungen aus unterschiedlichen Leuchtstoffen verwendet werden. Eine Vielzahl möglicher Leuchtstoffe ist aus dem Dokument [2] bekannt, dessen Offenbarung hiermit durch Rückbezug in das vorliegende Dokument aufgenommen wird. Die Anordnung der optoelektronischen Elemente erfolgt in Bezug zu einer optischen Achse, die als Normale durch die Öffnung der Aussparung verläuft, so dass die optoelektronischen Elemente Strahlung im Wesentlichen durch die Öffnung der Aussparung emittieren.

In einem dritten Schritt 504 wird die Aussparung mit einer Füllmasse aufgefüllt. Bei der Füllmasse handelt es sich um die in Bezug auf die Ausführungsbeispiele der **Fig. 1a** bis **Fig. 4b** beschriebene Füllmasse. Sie ist in aller Regel ein amorpher Festkörper, der in einer flüssigen Phase in die Aussparung eingebracht wird. Dabei werden die optoelektronischen Elemente vollständig bedeckt. Aufgrund der Oberflächenspannung der Füllmasse und der Kontaktspannung des Grundkörpers und des oberflächenstrukturierenden Elements wird eine Oberfläche der Füllmasse in zwei gewölbte Bereiche strukturiert. Diese Struktur, insbesondere die in zwei gewölbte Bereiche strukturierte Oberfläche der Füllmasse, wird in einem vierten Schritt 506 eingefroren, indem die Füllmasse, bspw. durch ein Aushärten, ein Abkühlen oder einen Glasübergang, verfestigt wird.

### ABSCHLIESSENDE FESTSTELLUNG

Das optoelektronische Halbleiterbauelement und das Verfahren zum Herstellen eines optoelektronischen Halbleiterbauelements wurden zur Veranschaulichung des zugrundeliegenden Gedankens anhand einiger Ausführungsbeispiele und eines nicht zur Erfindung gehörenden Erläuterungsbeispiels beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso denkbar, in Ausführungsbeispielen einzelne dargestellte Merkmale oder besondere Ausgestaltungen wegzulassen oder hinzuzufügen, soweit die allgemeine technische Lehre realisiert bleibt.

Auch wenn die Schritte des Verfahrens zum Herstellen eines optoelektronischen Halbleiterbauelements in einer bestimmten Reihenfolge beschrieben sind, so ist es selbstverständlich, dass jedes der in dieser Offenbarung beschriebenen Verfahren in jeder anderen, sinnvollen Reihenfolge durchgeführt werden kann, wobei auch Verfahrensschritte ausgelassen oder hinzugefügt werden können, soweit nicht von dem Grundgedanken der beschriebenen technischen Lehre abgewichen wird.

### LITERATUR

In diesem Dokument sind die folgenden Veröffentlichungen zitiert:
[1] DE 102 41 989 und
[2] WO 98/12757 A1.

**BEZUGSZEICHENLISTE**

| | |
|---|---|
| Grundkörper | 100 |
| Aussparung | 102 |
| Erstes optoelektronisches Element | 104 |
| Zweites optoelektronisches Element | 106 |
| Drittes optoelektronisches Element | 108 |
| Vorsprünge | 110 |
| Füllmasse | 112 |
| Erster Bereich der Oberfläche | 114 |
| Zweiter Bereich der Oberfläche | 116 |
| Dritter Bereich der Oberfläche | 118 |
| Vorsprünge | 200 |
| Erster Bereich der Oberfläche | 202 |
| Zweiter Bereich der Oberfläche | 204 |
| Dritter Bereich der Oberfläche | 206 |
| Erster Steg | 300 |
| Zweiter Steg | 302 |
| Dritter Steg | 304 |
| Vierter Steg | 306 |
| Erste Brücke | 400 |
| Zweite Brücke | 402 |
| Verankerung | 404 |

## Patentansprüche

1. Optoelektronisches Halbleiterbauelement umfassend:
- einen Grundkörper (100) mit einer darin gebildeten Aussparung (102)
- ein ersten optoelektronisches Element (104) und ein zweites optoelektronischen Element (106),
- ein oberflächenstrukturierendes Element und
- eine das erste optoelektronische Element (104) und das zweite optoelektronische Element (106) in die Aussparung (102) einbettende Füllmasse (112),
wobei
- das oberflächenstrukturierende Element eine Oberfläche der Füllmasse (112) derart gestaltet, dass wenigstens zwei gewölbte Bereiche (114, 116, 118) der Oberfläche bestehen,
- das oberflächenstrukturierende Element durch einen sich seitlich in die Aussparung (102) erstreckenden und darin eine Einschnürung bildenden Vorsprung (110, 200) des Grundkörpers (100) gebildet ist, und/oder
- das oberflächenstrukturierende Element durch einen in der Aussparung (102) verlaufenden Steg (304, 306) gebildet ist, der nicht mit seitlichen Innenflächen der Aussparung (102) sondern mit einer Grundfläche der Aussparung verbunden ist, und/oder
- das oberflächenstrukturierende Element (400, 402) brückenförmig in der Aussparung (102) ausgebildet und über jeweilige Verankerungen an dem Grundkörper befestigt ist und auf oder an der Oberfläche der Füllmasse (112) verläuft.

2. Optoelektronisches Halbleiterbauelement gemäß einem der vorangehenden Patentansprüche, wobei die zwei gewölbten Bereiche (114, 116, 118) jeweils konkav gewölbt sind.

3. Optoelektronisches Halbleiterbauelement gemäß einem der vorangehenden Patentansprüche wobei das erste optoelektronische Element (104) und das zweite optoelektronische Element (106) jeweils als Strahlungsquelle ausgestaltet sind.

4. Optoelektronisches Halbleiterbauelement gemäß Patentanspruch 3, wobei das erste optoelektronische Element (104) ein anderes Emissionsspektrum als das zweite optoelektronische Element (106) aufweist.

5. Optoelektronisches Halbleiterbauelement gemäß einem der vorangehenden Patentansprüche, wobei die Füllmasse (112) eine Vergussmasse ist.

6. Optoelektronisches Halbleiterbauelement gemäß Patentanspruch 5, wobei die Vergussmasse eines der folgenden Materialen aufweist:
- Epoxydharz;
- Akrylharz; und
- Silikonharz.

7. Optoelektronisches Halbleiterbauelement gemäß einem der vorangehenden Patentansprüche, wobei die Füllmasse (112) ein Diffusermaterial aufweist.

8. Optoelektronisches Halbleiterbauelement gemäß einem der vorangehenden Patentansprüche, wobei die Füllmasse (112) ein Absorbermaterial aufweist.

9. Verfahren zum Herstellen eines optoelektronischen Halbleiterbauelements umfassend:
- Bereitstellen eines Grundkörpers (100) mit einer darin gebildeten Aussparung (102) und einem oberflächenstrukturierenden Element;
- Anordnen von einem ersten optoelektronischen Element (104) und einem zweiten optoelektronischen Element (106) in der Aussparung (102); und
- Füllen der Aussparung (102) mit einer Füllmasse (112), wobei
- durch das oberflächenstrukturierende Element wenigstens zwei gewölbte Bereiche (114, 116, 118) einer Oberfläche der Füllmasse (112) gebildet werden
- das oberflächenstrukturierende Element durch einen sich seitlich in die Aussparung (102) erstreckenden und darin eine Einschnürung bildenden Vorsprung (110, 200) des Grundkörpers (100) gebildet ist, und/oder
- das oberflächenstrukturierende Element durch einen in der Aussparung (102) verlaufenden Steg (304, 306) gebildet ist, der nicht mit seitlichen Innenflächen der Aussparung (102) sondern mit einer Grundfläche der Aussparung verbunden ist, und/oder
- das oberflächenstrukturierende Element (400, 402) brückenförmig in der Aussparung (102) ausgebildet und über jeweilige Verankerungen an dem Grundkörper befestigt ist und auf oder an der Oberfläche der Füllmasse (112) verläuft.

10. Verfahren gemäß Patenanspruch 9 umfassend:
- Aushärten der Oberfläche der Füllmasse (112).

11. Verfahren gemäß einem der Patentansprüche 9 oder 10, wobei die Füllmasse (112) durch ein Abkühlen oder eine Glasübergang aushärtet.

12. Verfahren gemäß einem der Patentansprüche 9 bis 11, wobei die Füllmasse (112) durch Vergießen in die Aussparung (102) eingebracht wird.

## Claims

1. Method for reducing conductor track spacings in a printed circuit board, wherein the printed circuit board has an input part (PRI), which is fed by a supply voltage (U_{S}), and has an output part (SEC), **characterized by** the following steps:
- inserting an intermediate conductor track which has an intermediate potential (ZP) which is derived from the input part (PRI),
- maintaining a functional insulation gap (F) between the intermediate conductor track (5) and adjacent conductor tracks of the input part (PRI),
- maintaining a safety-relevant insulation gap (S) between the intermediate conductor track and the adjacent conductor tracks of the output part (SEC),
wherein the intermediate potential has, with respect to adjacent conductor tracks of the output part (SEC), a voltage which corresponds at most to the supply voltage (U_{S}) of the input part.

2. Method according to Claim 1, **characterized in that** the input part (PRI) cannot be touched.

3. Method according to Claim 1 or 2, **characterized in that** the output part (SEC) has components which can be touched.

4. Method according to one of Claims 1 to 3, **characterized in that** the intermediate potential (ZP) is generated from the potential at the negative output of a bridge rectifier (3) which is located in the input part.

5. Method according to one of Claims 1 to 3, **characterized in that** the intermediate potential (ZP) has a potential which corresponds to a lower voltage than the voltage between the input part and the output part (U₁, U₂, U₃, U₄) with respect to a ground potential or a potential of the neutral conductor of the supply voltage (U_{S}).

6. Method according to one of the preceding claims, **characterized in that** cutouts (7) are provided in the printed circuit board, between the intermediate conductor track (5) and adjacent conductor tracks of the input part (PRI) or adjacent conductor tracks of the output part (SEC), for the purpose of increasing the insulation gap.

7. Printed circuit board comprising a circuit arrangement, having:
- an input part (PRI), which is fed by a supply voltage (U_{S}), and
- an output part (SEC),
**characterized in that** the printed circuit board has, between the input part (PRI) and the output part (SEC), an intermediate conductor track which has an intermediate potential (ZP) which is derived from the input part,
wherein the intermediate conductor track maintains a functional insulation gap from the adjacent conductor tracks of the input part (PRI),
wherein the intermediate conductor track maintains a safety-relevant insulation gap from the adjacent conductor tracks of the output part (SEC),
wherein the intermediate potential (ZP) has a voltage which corresponds at most to the supply voltage (U_{S}) of the input part with respect to adjacent conductor tracks of the output part, or the intermediate potential (ZP) has a potential with a voltage of which the value is lower than that of the voltage between the input part and the output part (U₁, U₂, U₃, U₄) with respect to a ground potential or a potential of the neutral conductor of the supply voltage (U_{S}).

8. Printed circuit board according to Claim 7, **characterized in that** the input part (PRI) cannot be touched.

9. Printed circuit board according to Claim 7 or 8, **characterized in that** the output part (SEC) has components which can be touched.

10. Printed circuit board according to one of Claims 7 to 9, **characterized in that** the intermediate potential (ZP) is generated from the potential at the negative output of a bridge rectifier which is located in the input part (PRI).

11. Printed circuit board according to one of Claims 7 to 10, **characterized in that** cutouts (7) are provided in the printed circuit board, between the intermediate conductor track (5) and adjacent conductor tracks of the input part (PRI) or adjacent conductor tracks of the output part (SEC), for the purpose of increasing the insulation gap.

12. Printed circuit board according to one of Claims 7 to 11, **characterized in that** the intermediate potential (ZP) corresponds to a lower voltage than the voltage between the input part and the output part (U₁, U₂, U₃, U₄) with respect to a ground potential or a potential of the neutral conductor of the supply voltage (U_{S}).

## Revendications

1. Procédé de réduction de distances entre pistes conductrices d'une carte de circuit imprimé, la carte de circuit imprimé présentant une partie d'entrée (PRI) alimentée par une tension d'alimentation (Us) et une partie de sortie (SEC), **caractérisé par** les étapes suivantes :
- insertion d'une piste conductrice intermédiaire qui présente un potentiel intermédiaire (ZP) dérivé de la partie d'entrée (PRI),
- respect d'une distance d'isolation fonctionnelle (F) entre la piste conductrice intermédiaire (5) et des pistes conductrices voisines de la partie d'entrée (PRI),
- respect d'une distance d'isolation de sécurité (S) entre la piste conductrice intermédiaire et les pistes conductrices voisines de la partie de sortie (SEC),
le potentiel intermédiaire présentant, par rapport à des pistes conductrices voisines de la partie de sortie (SEC), une tension qui correspond au maximum à la tension d'alimentation (Us) de la partie d'entrée.

2. Procédé selon la revendication 1, **caractérisé en ce qu'**il n'est pas possible de toucher la partie d'entrée (PRI).

3. Procédé selon la revendication 1 ou 2, **caractérisé en ce que** la partie de sortie (SEC) comporte des composants qu'il est possible de toucher.

4. Procédé selon l'une des revendications 1 à 3, **caractérisé en ce que** le potentiel intermédiaire (ZP) est généré à partir du potentiel à la sortie négative d'un redresseur en pont (3) situé dans la partie d'entrée.

5. Procédé selon l'une des revendications 1 à 3, **caractérisé en ce que** le potentiel intermédiaire (ZP) présente un potentiel qui correspond à une tension plus faible que la tension entre la partie d'entrée et la partie de sortie (U1, U2, U3, U4) par rapport à un potentiel de terre ou un potentiel du conducteur neutre de la tension d'alimentation (Us).

6. Procédé selon l'une des revendications précédentes, **caractérisé en ce que** sont prévus, entre la piste conductrice intermédiaire (5) et des pistes conductrices voisines de la partie d'entrée (PRI) ou des pistes conductrices voisines de la partie de sortie (SEC), des évidements (7) ménagés dans la carte de circuit imprimé pour augmenter la distance d'isolation.

7. Carte de circuit imprimé avec un circuit, comportant :
- une partie d'entrée (PRI) qui est alimentée par une tension d'alimentation (Us),
- une partie de sortie (SEC),
**caractérisée en ce que** la carte de circuit imprimé présente, entre la partie d'entrée (PRI) et la partie de sortie (SEC), une piste conductrice intermédiaire qui présente un potentiel intermédiaire (ZP) dérivé de la partie d'entrée, la piste conductrice intermédiaire respectant une distance d'isolation fonctionnelle par rapport aux pistes conductrices voisines de la partie d'entrée (PRI),
la piste conductrice intermédiaire respectant une distance d'isolation de sécurité par rapport aux pistes conductrices voisines de la partie de sortie (SEC),
le potentiel intermédiaire (ZP) présentant, par rapport à des pistes conductrices voisines de la partie de sortie, une tension qui correspond au maximum à la tension d'alimentation (Us) de la partie d'entrée ou le potentiel intermédiaire (ZP) présentant un potentiel avec une tension plus faible, en termes de valeur, que la tension entre la partie d'entrée et la partie de sortie (U1, U2, U3, U4) par rapport à un potentiel de terre ou un potentiel du conducteur neutre de la tension d'alimentation (Us).

8. Carte de circuit imprimé selon la revendication 7, **caractérisée en ce qu'**il n'est pas possible de toucher la partie d'entrée (PRI).

9. Carte de circuit imprimé selon la revendication 7 ou 8, **caractérisée en ce que** la partie de sortie (SEC) comporte des composants qu'il est possible de toucher.

10. Carte de circuit imprimé selon l'une des revendications 7 à 9, **caractérisée en ce que** le potentiel intermédiaire (ZP) est généré à partir du potentiel à la sortie négative d'un redresseur en pont situé dans la partie d'entrée (PRI).

11. Carte de circuit imprimé selon l'une des revendications 7 à 10, **caractérisée en ce que** sont prévus, entre la piste conductrice intermédiaire (5) et des pistes conductrices voisines de la partie d'entrée (PRI) ou des pistes conductrices voisines de la partie de sortie (SEC), des évidements (7) ménagés dans la carte de circuit imprimé pour augmenter la distance d'isolation.

12. Carte de circuit imprimé selon l'une des revendications 7 à 11, **caractérisé en ce que** le potentiel intermédiaire (ZP) correspond à une tension plus faible que la tension entre la partie d'entrée et la partie de sortie (U1, U2, U3, U4) par rapport à un potentiel de terre ou un potentiel du conducteur neutre de la tension d'alimentation (Us).
